# EUROPEAN PATENT APPLICATION

(11) **EP 0 632 511 A2**
(43) Date of publication of application: **04.01.1995**
(21) Application number: 94110046.3
(22) Date of filing: 28.06.1994
(51) Int. Cl.: H01L 33/00, H01L 25/075, H01L 25/16

(54) **A light emitting diode aggregate module and a method for manufacturing a light emitting diode aggregate module**

(30) Priority: 29.06.1993 JP 35443/93; 30.06.1993 JP 35786/93; 30.06.1993 JP 162262/93
(71) Applicant: MITSUBISHI CABLE INDUSTRIES, Ltd., Amagasaki-shi, Hyogo-ken (JP)
(72) Inventor: Sano, Shinichi, c/o Itami Factory of, Itami-shi, Hyogo 664 (JP); Murata, Hiroaki, c/o Tokyo Office of Mitsubishi, 3-chome, Chiyoda-ku, Tokyo 100 (JP); Ohhori, Atsushi, c/o Minosima Factory of, Arita-shi, Wakayama 649-03 (JP); Futagami, Takeo, c/o Minosima Factory of, Arita-shi, Wakayama 649-03 (JP)
(74) Representative: Prüfer, Lutz H., Dipl.-Phys.

(57) **Abstract**

A light emitting diode aggregate module comprises a metallic base printed circuit board (1), light emitting diode chips (2) each of which is mounted on a bottom section of each hollow section (23) formed on the metallic base printed circuit board (1), electronic parts (3) which are mounted on the metallic base printed circuit board (1) and outside of the hollow sections (23), bonding wires (5b) each of which interconnects the light emitting diode (2) and each land section (5) which is formed in the hollow section (23), soft resin layers (6) each of which covers corresponding light emitting diode chip (2) and corresponding bonding wire (5b), and a lens board (20) which is formed in one body on the matallic base printed circuit board (1) by insert molding of translucent resin and has lens sections (20a) each of which corresponds to each light emitting diode chip (2).

## Description

### Background of The Invention

The present invention relates to a light emitting diode (hereinafter referred to as LED) aggregate module and a method for manufacturing an LED aggregate module. More particularly, the present invention relates to an LED aggregate module which includes a printed circuit board on which LED chips are mounted, and lens sections made of translucent resin each of which is disposed in correspondence to each LED chip, and a method for manufacturing the LED aggregate module.

### Description of The Related Arts

From the past, an n x n matrix type LED aggregate module or 1 x n line type LED aggregate module, both LED aggregate module including a printed circuit board on which LED chips are mounted and a lens board having plural lenses which lens board is stuck to the printed circuit board with adhesive agent and the like, for example, are known as LED aggregate modules.

When the LED aggregate module having the above-mentioned arrangement is manufactured, after mounting the LED chips and electronic parts on the printed circuit board, the lens board is stuck to the printed circuit board by interposing the adhesive agent and the like therebetween. Therefore, bubbles are highly possible to be contained in an adhesive layer made of the adhesive agent and the like. Further, a special matching operation is necessary, of optical axes of light emitting sections each section has the LED chip as a main portion and of the lens sections of the lens board, when the lens board is stuck to the printed circuit board. Therefore, sticking operation requires much labor, and it is raised its possibility that matching of optical axes is not performed with sufficiently high accuracy. Furthermore, the lens board is resin shrinked after the forming thereof. Therefore, warp is generated in the LED aggregate module based upon a difference between thermal expansion of the printed circuit board and thermal expansion of the lens board, when the lens board is stuck to the printed circuit board.

To eliminate the disadvantages above-mentioned, a method for manufacturing an LED aggregate module is thought, to omit sticking of the lens board using the adhesive agent and the like by mounting the LED chips and electric parts on the printed circuit board, thereafter forming the lens board by insert molding in which the printed circuit board is set in a die having lens cavities each corresponding to each LED chip, and molten resin is inserted in the die.

When the LED aggregate module is manufactured using the method above-mentioned, the inventors have found that peeling has occurred of land sections of a printed circuit from the printed circuit board, each of the land section being electrically connected the electric parts, and that breaking of the printed circuit caused by the peeling has occurred, and that yield of the LED aggregate module is lowered. More particularly, a force applied to the LED chip caused by the flow of the resin is not so great because a cross-sectional area is great of flowing of the resin concerning to the LED chip being rightly opposite to the lens portion of the lens board, that is the LED chip being located at a position which is covered by the lens cavity portion of the die. But, a force applied to the electric parts such as resistor caused by the flow of the resin is remarkably great because a cross-sectional area is extremely small of flowing of the resin in relationship to the electric parts being mounted at a position not to influence optical characteristics of the LED chip and lens section. Especially, when the electric parts is large in size, the force becomes especially great, peeling of the land section from the printed circuit board has occurred at a fairly high possibility, and breaking of a printed circuit pattern has occurred at peripheral portion of resist layer for covering the printed circuit pattern with respect to the printed circuit patten extending from the land section in a direction at a nearly right angle to a flowing direction of the resin.

Also, when the LED aggregate module is manufactured employing the method to omit sticking of the lens board using the adhesive agent and the like by mounting the LED chips and electric parts on the printed circuit board, thereafter forming the lens board by the insert molding, the inventors have found that a part of electric parts (most of electric parts in the worst case) are damaged, and that yield of the LED aggregate module is lowered.

Further, when the method for manufacturing an LED aggregate module is executed, to omit sticking of the lens board using the adhesive agent and the like by mounting the LED chips and electric parts on the printed circuit board, thereafter forming the lens board by the insert molding, depression generated in case that the resin for insert forming is cooled so as to be solidified (shrinkage of the resin generated in case that the resin for insert molding is cooled so as to be solidified) applies pulling force to a bonding wire so that connection of the bonding wire with the land section and/or the LED chip is obstructed in the worst case. Therefore, plural hollows are formed on the printed circuit board, each LED chip is mounted in each hollow, silicon resin for protecting the bonding wire is previously (prior to insert molding) stored in the hollows so as to cover the whole extent of the bonding wire which interconnects the LED chip and the land section.

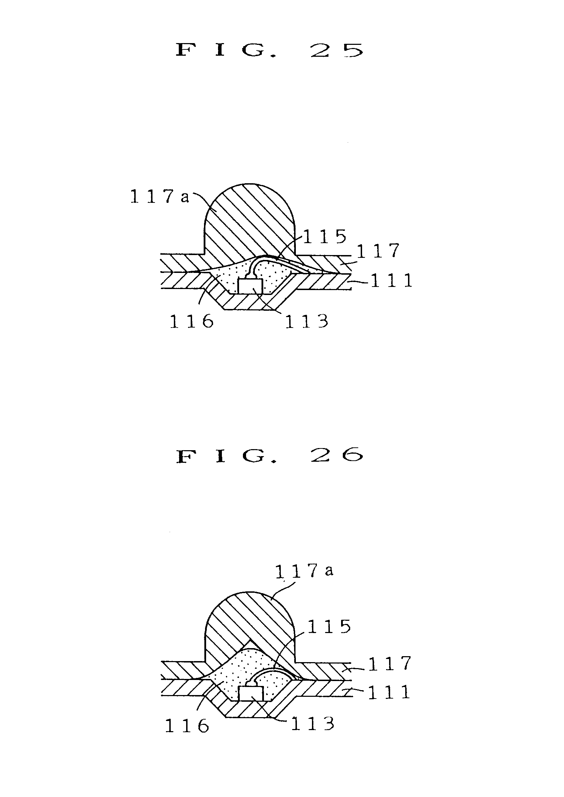

When the LED aggregate module is manufactured by forming the lens board in one body by the insert molding above-mentioned, as is illustrated in Fig. 25, a top face of the silicon resin 116 for protecting the bonding wire cannot be a flat face concerning to a part of the bonding wire 115 being projected upward from a surface of the printed circuit board 111, central portion (exactly speaking, a portion corresponding to a portion of the bonding wire locating at the uppermost position) of the top face of the silicon resin 116 becomes upward projecting condition, so that the silicon resin 116 itself has lens characteristics. Consequently, lens characteristics of the finally obtained LED aggregate module cannot be determined to be predetermined lens characteristics, because the lens characteristics of the silicon resin 116 is superimposed to the lens characteristics of the lens section 117a of the lens board 117, even when design of the forming die, selection of the resin for insert molding and the like are performed so that the lens section 117a of the lens board 117 having a desired lens characteristics, the lens board 117 being formed in one body by the insert molding. Meanwhile, the lens characteristics of the silicon resin 116 vary depending upon the degree of curvature, the projecting distance upward from the top face of the printed circuit board 111, and the like of the bonding wire 115, therefore, it is almost impossible that the lens characteristics of the lens section 117a of the lens board 117 formed in one body is designed by previously taking the lens characteristics of the silicon resin 116 into consideration. Consequently, the lens characteristics of the finally obtained LED aggregate module cannot be determined to be the desired lens characteristics.

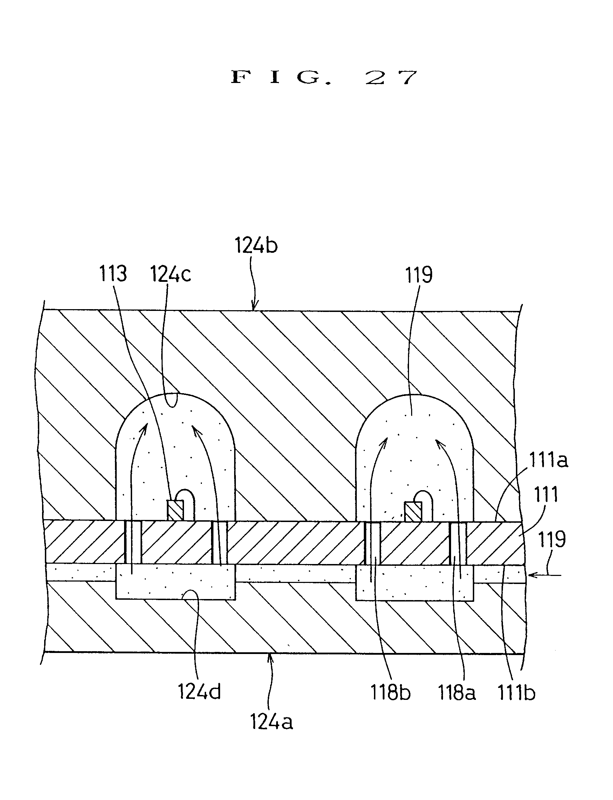

Though, the silicon resin 116 is partially projected upward, the depression of the resin for insert molding is easily concentrated at the upward projecting portion of the silicon resin 116, so that a space 116a is formed at the concentrated portion of the depression which space 116a cannot be ignored in optical characteristics (refer to Fig. 26). And, at the boundary of the space 116a and the silicon resin 116, difference of index of refraction differs from the designed value to some degree, so that a part of emitted light from the LED chip 113 is reflected at the boundary face causing intensity of the emitted light from the LED aggregate module to be decreased.

Further, a method for manufacturing the LED aggregate module is known in which method the electric parts mounted on the printed circuit board are molded in one body with the printed circuit board (refer to Japanese Patent Publication Tokukouhei 3-60189). Fig. 27 is a cross-section view schematically illustrating a conventional molding method to the mounted LED chip on the printed circuit board as an example of the electric parts. As is illustrated in Fig. 27, in the conventional method for molding, a pair of through holes 118a and 118b are formed in the printed circuit board 111 in neighbouring of each LED chip 113 mounted on one face 111 a of the printed circuit board 111, the LED chips 113 together with the printed circuit board 111 are surrounded by an upper die 124b which has plural cavities 124c each having predetermined lens shape and corresponding to each LED chip 113, and a lower die 124a which has cavities 124d each acting as brasin corresponding to each cavity 124c in the other face 111 side of the printed circuit board 111. Resin 119 for molding is injected from the cavity 124d side of the lower die 124a, the injected synthetic resin 119 is guided interior the cavities 124c having the lens shape via the through holes 118a and 118b so as to mold the LED chips 113 in one body.

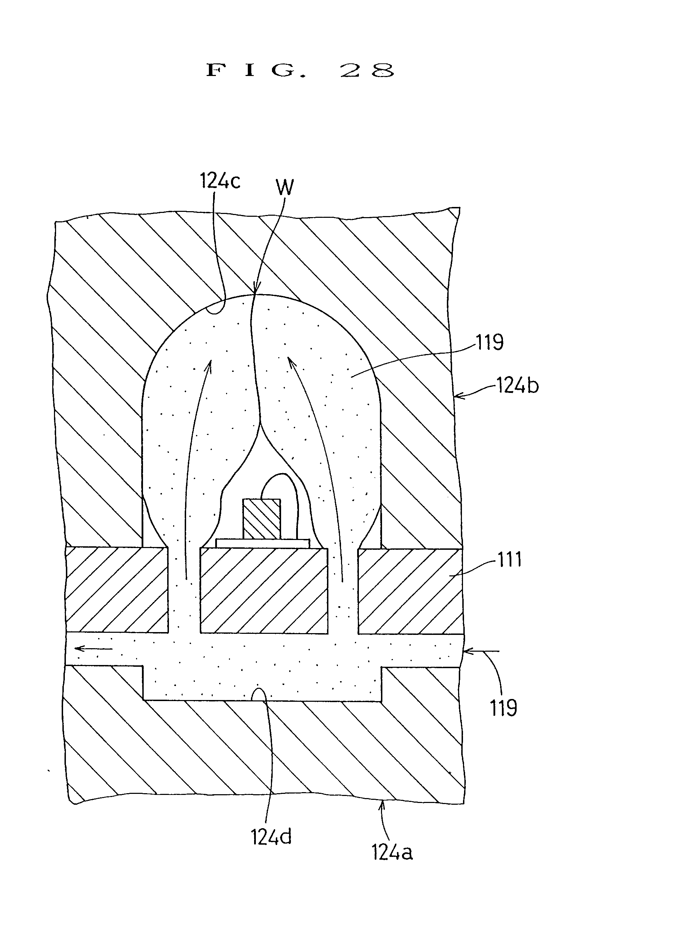

Though the method for molding injects the resin 119 from rear side ward of the printed circuit board, and the resin 119 flows into the cavities 124c at the lens side via the two through holes 118a and 118b, the resin 119 is confluent in an effective portion of the lens so as to generate line shaped nonuniformity (weld line) w, as is illustrated in Fig. 28. The weld line causes defectiveness in penetration characteristics of light, defectiveness in appearance and the like.

On the contrary to the method, when the resin 119 is directly injected from the cavity 124c side for lens, the resin 119 strongly contacts the side face of the cavities 124c so as to generate a flow mark of the resin remaining in line shape in the effective portion of the lens which is similar to the weld line, and so as to be filled the resin in strap shape and in buckling condition so that a surface structure which is in strap shape and in squeezed condition (jetting) is generated. Therefore, disadvantages as similar as of the above-mentioned arise.

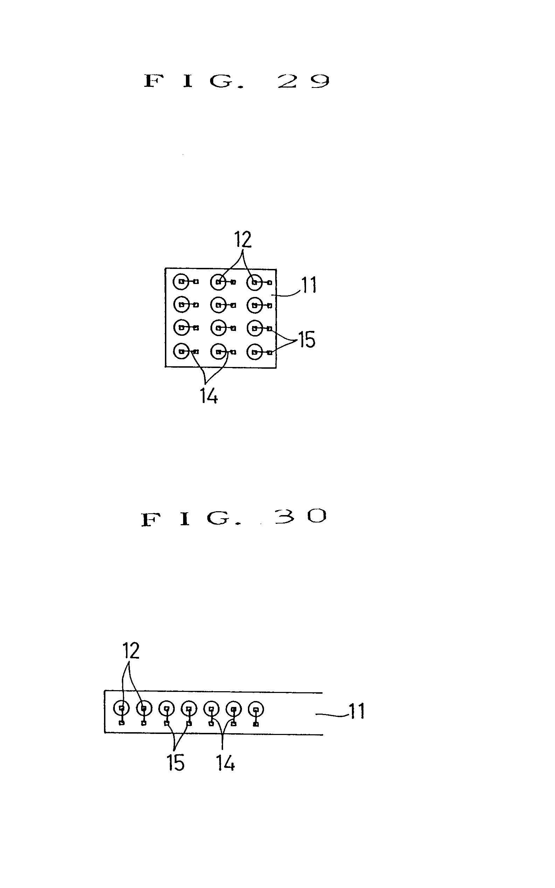

Further, the n X n matrix type LED aggregate module is manufactured, for example, as is illustrated in Fig. 29, by mounting n X n-number of LED chips on the printed circuit board in matrix pattern. In the LED aggregate module illustrated in Fig. 29, all land sections for electrically connecting each LED chip with printed circuit on the printed circuit board are disposed in right side with respect to the corresponding LED chip. Therefore, bonding wires each interconnecting each LED chip and the corresponding land section extend in the right side with respect to corresponding LED chips.

The 1 X n line type LED aggregate module is manufactured, for example, as is illustrated in Fig. 30, by mounting n-number of LED chips on the printed circuit board in line pattern. In the LED aggregate module illustrated in Fig. 30, all land sections for electrically connecting each LED chip with printed circuit on the board are disposed in this side with respect to the corresponding LED chips. Therefore, bonding wires each interconnecting each LED chip and the corresponding land section extend in this side with respect to corresponding LED chips.

When the LED aggregate modules having the above-mentioned arrangement are employed, though relative positions of the land sections with respect to corresponding LED chips are constant, moving patterns for bonding are made uniform when each LED chip and the corresponding land section is interconnected by the bonding wire using an industrial robot and the like, so that the LED aggregate modules can be manufactured easily.

In the LED aggregate modules having the arrangement above-mentioned, though directions of the bonding wires with respect to corresponding LED chips are the same to one another, a part of light outgone in the same direction (a direction in which bonding wires exist) to one another among the light outgone from all LED chips is screened by the bonding wires, so that luminous intensity distribution characteristics of the LED aggregate module as a whole is spoiled.

Specifically, when the LED aggregate module is stood vertically, and on a plane which is apart from the center of the LED aggregate module by 3 meters in horizontal direction, locations 5° and 100 upward from the center of the LED aggregate module with respect to the horizontal line, locations 5 and 100 downward from the center of the LED aggregate module with respect to the horizontal line, locations 5 and 10° rightward from the center of the LED aggregate module with respect to the horizontal line, locations 5 and 10 leftward from the center of the LED aggregate module with respect to the horizontal line are selected, and luminosity at each location is measured, luminous energy at locations 5° and 10 rightward are smaller than that of at locations 5 and 10 ° leftward with the LED aggregate module illustrated in Fig. 29 employed, while luminous energy at locations 5 and 10 downward are smaller than that of at locations 5 and 10 upward with the LED aggregate module illustrated in Fig. 30 employed.

Therefore, it is difficult in the LED aggregate module which is required functioning as plane illuminant that the LED aggregate module is functioned as a plane illuminant with sufficiently uniformity in a higher level.

### Summary of The Invention

It is an object of this invention to improve yield of LED aggregate module.

It is another object of this invention to form a lens board directly on a printed circuit board by forming in one body of resin and to decrease breakage of electronic parts to zero.

It is a further object of this invention to extremely decrease peeling of a land section to which the electronic parts is electrically connected, from the printed circuit board, and breaking of a printed circuit pattern.

It is still another object of this invention to facilitate fitting of the lens board to the printed circuit board, and to improve reliability by lessening warp of the printed circuit board.

It is a still further object of this invention to improve quality of lens sections of the lens board which is formed in one body to the printed circuit board.

It is yet another object of this invention to obtain a predetermined lens characteristics, and to suppress lowering of outgone light intensity.

It is an yet further object of this invention to function the LED aggregate module as a plane illuminant with sufficiently uniformity in a higher level.

An LED aggregate module according to this invention comprises;
a metallic base printed circuit board having plural hollows thereon, a predetermined printed pattern, LED chips each mounted in a bottom portion of the hollow, and electronic parts each mounted at a location which is different from a mounted location of the LED chip,
a soft resin layer for surrounding peripheral portion of the LED chips,
a protection layer made of resin for covering a part or entirety of the electronic parts, and
a lens board which is formed by injection of translucent resin into a molding die and is disposed in contact on a surface of the printed circuit board, the lens board covering the plural LED chips and the electronic parts, and having lens sections projecting forward at a location corresponding to each LED chip.

As to the LED aggregate module, a light radiated from the LED chip is effectively guided forward by the hollow and the lens section. And, disadvantages are prevented by the soft resin layer from occurring, the disadvantages possibly being applied to the LED chips when the lens sections are formed. Further, a force is escaped by the protection layer, the force possibly be applied to the electronic parts when the translucent resin is injected in the molding die. Furthermore, though adhesive agent is no need, bubbles are not possibly contained between the printed circuit board and the lens board, and no special matching operation is needed, of optical axes of light emitting sections each section having the LED chip as a main portion and of the lens sections.

It is preferable that a rectangular shaped printed circuit board is employed, claw sections are formed in one body at edge sections excluding corner sections of the lens board, and fixation of the printed circuit board and the lens board is performed by the claws. In this case, shrinking force of the lens board in its diagonal direction after forming is released at the corner sections of the lens board, so that the warp of the LED aggregate module is supprerssed.

It is also preferable that the printed circuit board further has through holes, and fixation of the printed circuit board and the lens board is performed by going round the resin for lens board to the opposite face side of the printed circuit board through the through holes. In this case, incorporation of the lens board and the printed circuit board in one body is performed simultaneously with the manufacturing of the lens board. In this case, it is more preferable that the through holes are formed in neighbouring of the mounted section of each LED chip, and the LED chips are substantially surrounded by the resin for lens board.

Also, it is preferable that the protection layer for the electronic parts is formed in a shape which reduces resistance against the flowing of the translucent resin for lens board when the translucent resin is injected in the molding die. In this case, resistance is reduced when the translucent resin for lens board is injected so that the injection of the translucent resin in the molding die is smoothly performed, and that the electronic parts are extremely decreased the degree of influence caused by the flowing of the translucent resin.

Further, it is preferable that the printed circuit extending from the land section among the printed circuit on the printed circuit board, is provided in a direction of flowing of the translucent resin when the translucent resin is injected in the molding die, the land section being electrically connected the electronic parts at least. In this case, even when a force in peeling direction is applied to the land section by being influenced by the flowing of the translucent resin when the translucent resin is injected in the molding die, a twisting force is prevented from functioning to the printed circuit so that the possibility of breaking of the printed circuit is extremely reduced.

Furthermore, it is preferable that the soft resin layer for covering peripheral portion of the LED chip is housed in the hollow so as to make the surface of the soft resin flat and coincident with the surface of the printed circuit board. In this case, depression generated when the translucent resin for lens board is solidified, is prevented from locally concentrating, so that a disadvantage is prevented from occurring that the lens characteristics is degradiated by the depression. In this case, it is further preferable that a step section is provided in a predetermined location of each hollow.

Furthermore, it is preferable that the land sections on the printed circuit board each is connected to an upper electrode of each LED chip by a bonding wire are provided, extending directions of the bonding wire with respect to the LED chip are determined at least two directions, a number of the bonding wires extending in each direction is determined nearly equal to one another, for preventing the LED aggregate module from not obtaining sufficient plane luminance characteristics caused by shielding the light radiated from the LED chips by the bonding wires. In this case, relative location (relative direction) of the radiated light from the LED chip, influenced by the bonding wire is determined based upon the extending direction of the bonding wire, and the ratio of each relative location becomes nearly equal to one another. Therefore, on an illuminated plane which receives influence of light radiated from all LED chips almost nearly to one another, influence of the bonding wires is not locally accentuated so that the LED aggregate module functions as a sufficiently uniform plane illuminant in a higher level.

A method for manufacturing an LED aggregate module comprises the steps of;
a step for housing a printed circuit board on which LED chips are mounted in a molding die which has plural cavities for lens corresponding to a front face side of the printed circuit board, and
a step for injecting translucent resin for lens board in the molding die through one or more injection gates and runners which are provided in the molding die so that the translucent once collides against the front face of the printed circuit board, then the translucent resin flows into the cavities along the front face of the printed circuit board.

In this case, adhesive agent and the like is not needed at all, therefore bubbles are not possibly contained between the printed circuit board and the lens board, and no special matching operation is necessary, of optical axes of light emitting sections each section has the LED chip as a main portion and of the lens sections of the lens board. Consequently, operability for manufacturing LED aggregate modules is improved.

It is preferable that the method further comprises a step for forming through holes in the printed circuit board at locations each of which is near the mounted section of each LED chip, and is located at a position which is covered by each cavity for lens, and
wherein the step for housing the printed circuit board in the molding die is a step for housing the printed circuit board on which the LED chips are mounted in the molding die which has plural cavities for lens corresponding to the front face side of the printed circuit board and plural cavities for fixing lens corresponding to rear face side of the printed circuit board, each cavity for fixing lens facing to corresponding cavity for lens, and
the step for injecting the translucent resin for lens board is a step for injecting the resin for lens board to flow into the cavities for lens and for injecting the resin for lens board to flow into the cavities for fixing lens through the cavities for lens and the through holes

In this case, incorporation of the lens board and the printed circuit board in one body is performed simultaneously with the manufacturing of the lens board. Also, the lens board is strongly united with the printed circuit board.

It is preferable that the method further comprises a step for forming protection layers made of soft resin on the surface of LED chips mounted on the printed circuit board prior to housing the printed circuit board in the molding die. In this case, disadvantages are prevented by the soft resin layers from occurring, the disadvantages being possibly applied to the LED chips when the lens sections are formed. In this case, it is more preferable that the method further comprises a step for forming plural hollows in the printed circuit board, and wherein each of the LED chips is mounted at a bottom portion of each hollow. In this case, it is further preferable that the method further comprises a step for forming step sections each being in a predetermined location of each hollow.
It is preferable that the method further comprises a step for mounting electronic parts on the printed circuit board, and
a step for covering a part or entirety of each mounted electronic parts to form a protection layer thereon.

In this case, a force is escaped by the protection layer, the force possibly functioning to the electronic parts when the translucent resin is injected in the molding die.

It is preferable that the method further comprises a step for mounting LED chips on the printed circuit board in an arranged in matrix pattern condition, and wherein a plurality of injection gates are formed in the molding die, a number of injection gates corresponding to a mounted number of the LED chips and each injection gate being located at nearly central position of more than two mounted LED chips on the front face of the printed circuit board, and the translucent resin for lens is injected from each injection gate, respectively.

In this case, the method is suitable for molding the lens board for the large sized LED aggregate module having a plurality of LED chips, for instance, and performs the injection of the translucent resin into all cavities for lens smoothly and almost uniformly.

It is preferable that the method further comprises a step for forming the soft resin layers each covering all surface of each LED chip, and surface of each soft resin layer being flat and coincident with the surface of the printed circuit board.

In this case, depression generated when the translucent resin for lens board is solidified, is prevented from locally concentrating, so that a disadvantage is prevented from occurring that the lens characteristics is degradiated by the depression.

### Brief Description of The Drawings

Figure 1 is a vertical cross sectional view schematically illustrating an embodiment of a manufacturing method of an LED aggregate module;
Figure 2 is a schematic perspective view illustrating an embodiment of an LED aggregate module;
Figure 3 is an enlarged vertically cross sectional view taken along a line III-III in Fig. 2;
Figure 4 is a schematic perspective view of another embodiment of an LED aggregate module;
Figure 5 is a schematic rear view of the LED aggregate module in Fig. 4;
Figure 6 is a partially enlarged vertical cross sectional view illustrating an engaged condition of a printed circuit board at an engagement section;
Figure 7 is a partially enlarged vertical cross sectional view illustrating an engaged condition of the printed circuit board at another engagement section;
Figures 8(A) to 8(C) are vertical cross sectional views of another embodiment of a manufacturing method of the LED aggregate module;
Figure 9 is a schematic view explaining a relationship of an electronic parts and a protection layer;
Figure 10 is a schematical view illustrating insert molding;
Figure 11 is a vertical cross sectional view illustrating a further embodiment of an LED aggregate module;
Figure 12 is a perspective view schematically illustrating mounted condition of an electronic parts;
Figure 13 is a perspective view schematically illustrating mounted condition of an electronic parts in still another embodiment of an LED aggregate module;
Figure 14 is a plan view illustrating a still further embodiment of an LED aggregate module;
Figure 15 is a cross sectional view taken along an XV-XV line in Fig. 14;
Figure 16 is a graph showing a luminous intensity distribution characteristics measurement result of the LED aggregate module in Fig. 14;
Figure 17 is a plan view illustrating a conventional LED aggregate module;
Figure 18 is a graph showing a luminous intensity distribution characteristics measurement result of the LED aggregate module in Fig. 17;
Figure 19 is a plan view illustrating an embodiment of a 1 X n line type LED aggregate module;
Figure 20 is a plan view illustrating another embodiment of a 1 X n line type LED aggregate module;
Figure 21 is a plan view illustrating an embodiment of an n X n matrix type LED aggregate module;
Figure 22 is a plan view illustrating a main portion of yet another embodiment of an LED aggregate module;
Figure 23 is a vertical sectional view of the LED aggregate module in Fig. 22;
Figures 24(A)-(E) are vertical sectional views explaining a further embodiment of a manufacturing method of an LED aggregate module;
Figure 25 is a vertical sectional view illustrating a main portion of a conventional LED aggregate module;
Figure 26 is a vertical sectional view illustrating a main portion of a conventional LED aggregate module;
Figure 27 is a vertical sectional view illustrating a conventional manufacturing method of an LED aggregate module;
Figure 28 is a vertical sectional view illustrating a disadvantage raised by the conventional manufacturing method of an LED aggregate module;
Figure 29 is a plan view illustarting a conventional n X n matrix type LED aggregate module; and
Figure 30 is a plan view illustrating a conventional 1 X n line type LED aggregate module.

### Detailed Description of The Preferred Embodiments

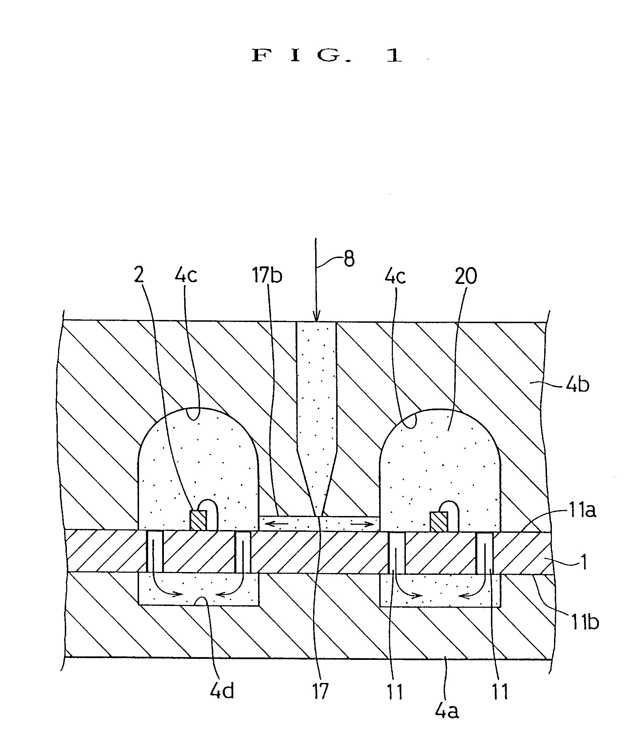

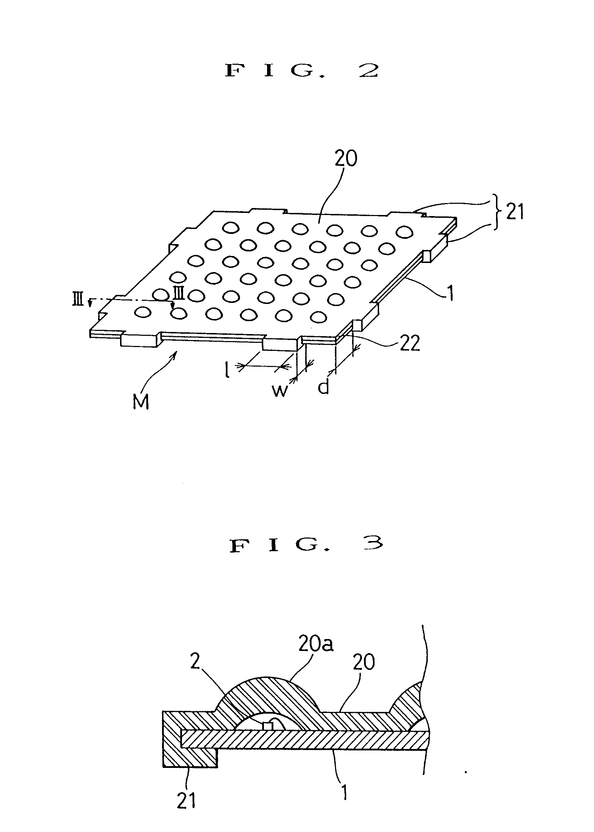

Figure 1 is a vertical cross sectional view schematically illustrating a molding method according to this invention. As is illustrated in Fig. 1, the molding method is a method for molding LED chips 2 by moldimg synthetic resin coverage layer 20 which surrounds in one body the LED chips 2 and rear face portions 11 b of a printed circuit board 1, via through holes 11 of the printed circuit board 1, each through hole 11 being formed in the neighbouring of the LED chip 2 mounted on the printed circuit board 1, and is a method for forming one or more injection gates 17 which direct against a front face portions 11 a of the printed circuit board 1, each injection gate neighbouring a cavity 4c existing in an LED chip mounted side, flowings of source resin 8 injected from the injection gates 17 are once collided against the front face portions 11 a of the printed circuit board 1, then the source resin is flowed in the cavities 4c existing in the LED chip mounted side. Further, reference numeral 4d indicates a rear side cavity. The rear side cavity 4d is communicated with the cavity 4c via the through holes 11.

Location of each injection gate 17 with respect to the cavity 4c may be any location which enables the flowing of the source resin once colliding against the front face of the printed circuit board 1. It is preferable that the injection gates 17 are formed at least 1-2 mm apart from an edge portion of the cavity 4c by taking influence into consideration of the source resin to flowing path after collision against the front face of the printed circuit board 1. If circumstances require, the resin flowing path may be extended from one cavity to another cavity, and the another cavity is filled with the source resin after the one cavity has been filled with the source resin.

A solidified synthetic resin corresponding to a resin flowing path 17b from the injection gate to the cavity (hereinafter referred to as a runner) according to this embodiment may be remained on the printed circuit board as a finished goods, or may be removed therefrom.

The runner 17b is preferably formed by employing the front face 11 a of the printed circuit board 1 as a part of side walls of the runner 17 so that the source resin flows to the cavity 4c along the front face 11 a of the printed circuit board 1. But, the runner 17b may be a runner which flows the source resin apart from the printed circuit board 1 after collision of the source resin against the printed circuit board 1.

A path of the runner 17b beginning from the injection gate 17 and ending to the cavity 4c is preferably formed to be the shortest route except bypassing obstacles such as circuits on the printed circuit board 1. But, the runner 17 may be formed as a runner path which turns by a predetermined number of times to avoid a simple straight line path by taking problems into consideration such as deformation of lens caused by shrinking, depression and the like of the resin.

A section shape of the runner 17b is a known shape such as a semicircle shape, trapezoid shape and the like when the runner contacts the printed circuit board 1 as usual, and such as a circle shape and the like when it is required.

A section area in diameter direction of the runner 17b is determined to be a proper value based upon molding condition such as species, temperature of the translucent resin for lens board, temperature of the molding die, injection pressure, injection speed, injection time and the like, and other various condition such as appearance when the runner is remainded in the manufactured goods. But, a section area may be continuously varied from the injection gate 17 towards the cavity 4c so as to control the flowing speed, pressure and the like of the translucent resin.

A location uniting the runner 17b with the cavity 4c is preferably determined so that the translucent resin flows in the cavity so as to fill the cavity 4c, and then the translucent resin flows in the rear face side of the printed circuit board, by taking the location relationship with the through holes 11 into consideration.

Further, the runner may be a runner as a special example, which forms a translucent resin layer covering a part or its entirety of the front face side which is the mounting side of the printed circuit board. and which does not provide a runner extending along a special path.

In this embodiment, the LED chips are mounted on the printed circuit board which is to be a display panel, the translucent resin coverage layer is formed thereto using the molding method ac- coding to this invention, then quality of effective portion of the lens is recognized.

Polycarbonate is employed as the translucent resin for molding, the translucent resin is injected by an outlet pressure of 1500kgf/cm² of an extruding machine from the injection gate 17 which is provided at intermediate portion of two cavities 4c and 4c as is illustrated in Fig. 1. The LED chips 2 and the rear face portion of the printed circuit board 1 corresponding to the LED chips are formed in one body via the through holes 11 by molding, so that the LED aggregate module having the translucent coverage layer as lens board is obtained. When quality of lens portions of the LED aggregate module is evaluated, the LED aggregate module being obtained by the experimental method for manufacturing, no generation of weld lines, flow marks, jetting and the like was made in the effective portion of the lens portion, and the translucent resin is filled up to 100% both in front and rear portions of the printed circuit board 1, so that it is recognized that the LED aggregate module has good quality.

From the experimental method for manufacturing, it is recognized that the molding method of this invention is effective to the formation of lenses each corresponding to the LED chip mounted on the printed circuit board 1.

### Second Embodiment

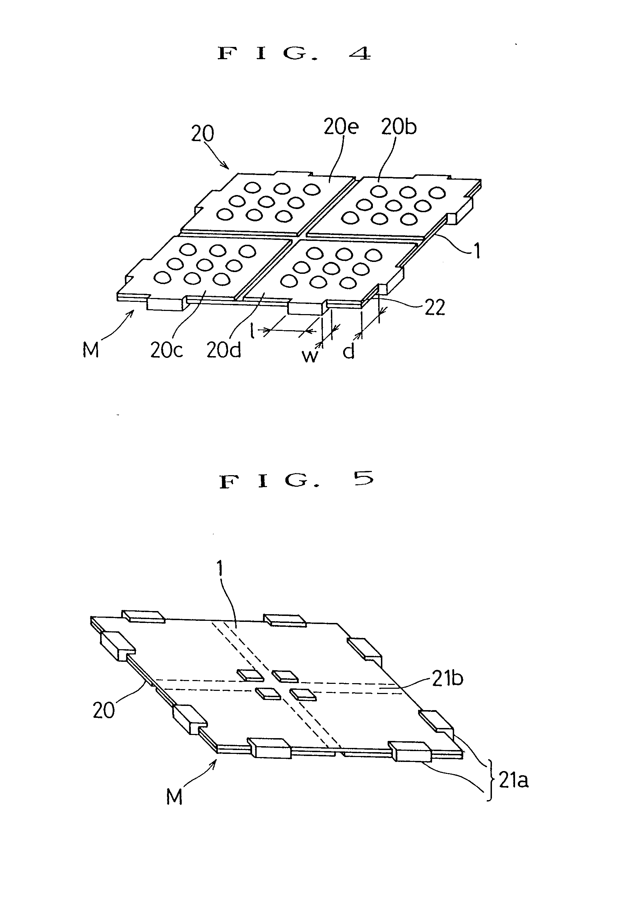

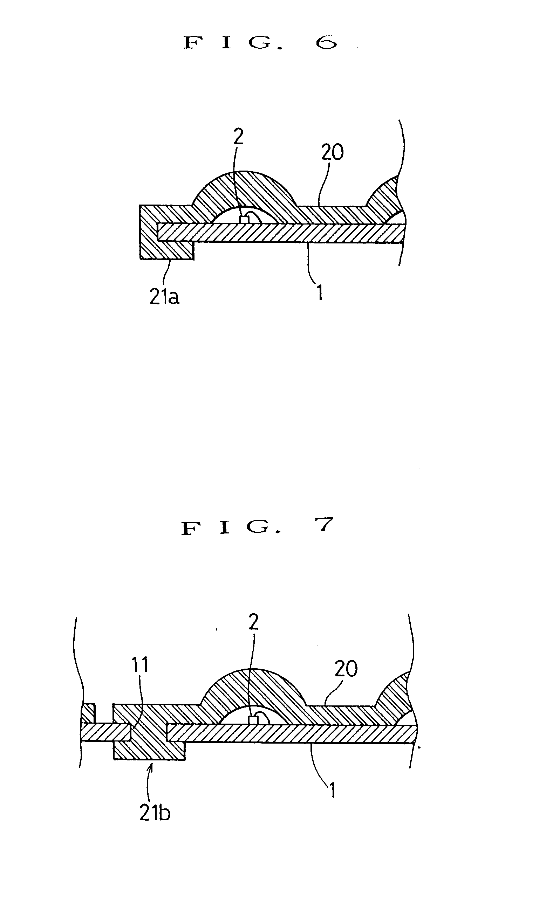

Figure 2 is a schematic perspective view illustrating an embodiment of an LED aggregate module. In Fig. 2, the reference character M indicates an LED aggregate module, and a printed circuit board 1 on which LED chips ( not illustrated) are mounted is engaged with engagement sections 21 formed in a lens board 20.

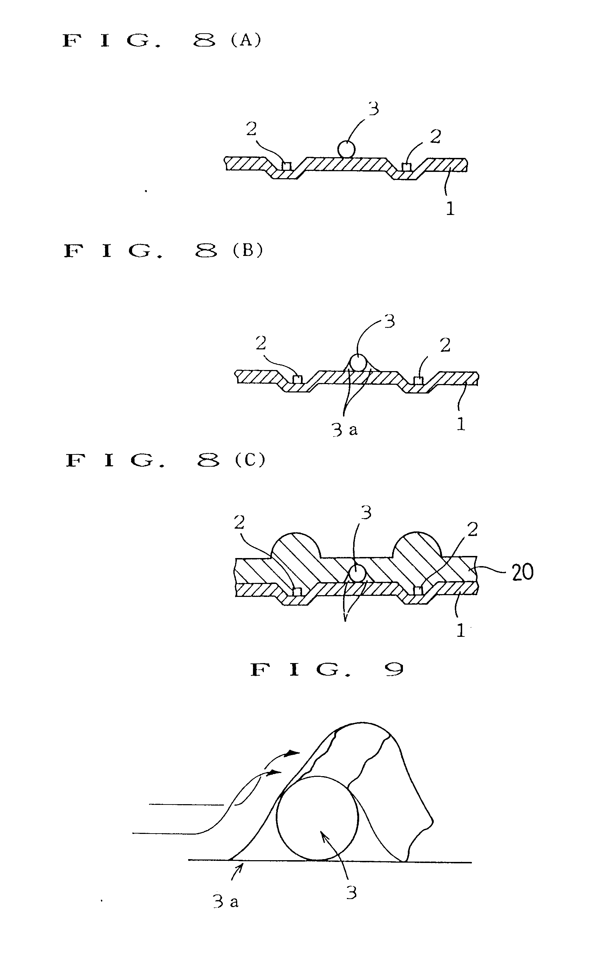

Figure 3 is an enlarged cross sectional view taken along a line III-III in fig. 2, and illustrates an engagement condition at the engagement section 21. The printed circuit board 1 on which the LED chips 2 are mounted, is engaged with enganement sections 21 formed in the lens board 20 having lens sections 20a.

The enganement sections 21 are formed in edge portions excluding corner portions of the lens board 20. The edge portions excluding the corner portions are meant portions each aparting from corresponding apex portions 22 by a distance d of at least 2 mm, preferably by a distance d of 4-30 mm. Further, a size of the engagement section 21 varies depending upon the size of the LED aggregate module. A width w and a length I of the engagement section 21, as is illustrated in Fig. 2, are proper to be in sizes of about more than 0.5 mm, respectively, in usual case.

In this embodiment, it is not preferable that the width w or the length I is lesser than 0.5 mm, because the printed circuit board 1 and the lens board 20 may not stably be fixed to one another.

Further, the width w and a length I of the engagement section 21 are preferable that they are as large as possible in size so as to securely fix the printed circuit board, when they are within an extent that they are not too large with respect to the size of the LED aggregate module, and that a disadvantage does not arise in greatly increasing in the amount of the translucent resin for lens board used.

Further, in this embodiment, the engagement sections 21 are formed at least one location, preferably at two locations interposing each apex 22 of the lens board 20, per each side of the lens board 20. When the length of the engagement sections 21 is short, the engagement sections 21 may be formed more than three locations per each edge of the lens board 20.

Mode of the engagement sections 21 is not specially limited as possible as fixing the printed circuit board 1 and the lens board 20. But, the engagement section 21 is preferable to be a claw shaped engagement section 21 as is illustrated in the cross sectional view of Fig. 3.

The method for forming the lens board 20 is not specially limited, but is preferable to employ insert molding which enables forming in one body of the claw shaped engagement sections 21 with the lens board 20 easily.

The lens board 20 is made of resin having high translucency. The resin is exemplified with epoxy resin, silicon resin, acrylate resin, polycarbonate and the like.

A usually employed printed circuit board is employed as the printed circuit board 1. The printed circuit board 1 is exemplified with a metallic based printed circuit board which is made by painting or adhered in film shape of insulation material such as epoxy resin, polyethylene, polyimide, polyester and the like on a surface of a matallic board such as alminium, copper, iron, stainless steel, nickel and the like.

As to the arrangement above-mentioned, though the printed circuit board 1 on which the LED chips 2 are mounted is engaged by the engagement sections 21 formed in one body in the lens board 20 when the lens board 20 is formed, adhesive agent which is required in the conventional LED aggregate module is not needed at all. Also, disadvantage in containing bubbles in the adhesive agent layer when the printed circuit board 1 and the lens board 20 are adhered to one another, and labor for assembling the printed circuit board 1 and the lens board 20 such as matching operation of optical axes of light emitting sections each section has the LED chip as a main portion and of the lens sections of the lens board 20 are eliminated. Consequently, the LED aggregate module is manufactured easily. Further, in this embodiment, though the engagement sections 21 are formed in one body in the edge portions excluding the corner portions of the lens board 20, shrinking forces in diagonal directions of the lens board 20 after formation of the lens board 20 are dispersed and released.

As a result, warp of the LED aggregate module caused by resin shrinking of the lens board 20 immediately after forming is prevented from occurring, for example.

### Third Embodiment

Figure 4 is a schematic perspective view of another embodiment of an LED aggregate module. In Fig. 4, the reference character M indicates an LED aggregate module which has an arrangement that a printed circuit board 1 on which LED chips 2 are mounted is covered by a lens board 20 which is divided into multiple number of lens boards 20b, 20c, 20d and 20e each having a small area.

Figure 5 is a schematic bottom view of the LED aggregate module. In Fig. 5, a reference numeral 21 a indicates engagement sections formed in one body in the lens board 20. The engagement sections 21 a are formed in edge portions excluding corner portions 22 of the lens board 20, the corner portions 22 each corresponding to each apex of the printed circuit board 1 on which the LED chips 2 are mounted. Also, the reference numeral 21 b indicates engagement sections formed in one body in the lens board 20. The engagement sections 21 b are formed in corner sections each locating in diagonal direction with respect to each corner section 22 of the lens board 20. Figure 6 is a partially enlarged vertical cross sectional view illustrating an engaged condition of a printed circuit board 1 at the engagement section 21 a of the lens board 20. In Fig. 6, the printed circuit board 1 is engaged its outer side edge portions by the engagement sections 21 a formed in one body in the lens board 20 which covers the front face of the printed circuit board 1 on which the LED chips 2 are mounted.

Further, Figure 7 is a partially enlarged vertical cross sectional view illustrating an engaged condition of the printed circuit board 1 at the engagement section 21 b of the lens board 20. In Fig. 7, the engagement section 21 b is formed by that the translucent resin for lens board passes through the through holes 11 so as to be filled in the rear face side of the printed circuit board 1, the through holes 11 penetrating the printed circuit board 1 in its thickness direction on which the LED chips 2 are mounted. The engagement sections 21 b engage the central portions of the printed circuit board 1.

The LED aggregate module of this embodiment is manufactured by partitioning the printed circuit board 1 which is housed interior a cavity of a forming die into multiple numbered small portions, and by insert molding the lens board 20 in every partition independently. At the same time, the engagement sections 21 a and 21 b are formed in one body.

The lens board 20 is formed in a condition that the partitioned portions have area of 200-3000 mm², respectively. Each partitioned portion preferably has an area of 600-800 mm^{2.} When the area of the partitioned portion exceeds 3000 mm², the degree of resin shrinking becomes great in each of the partitioned portions so that influence to the printed circuit board becomes great, while the lens board 20 is more fractionated than the lens board 20 needs so that its formation and fixation to the printed circuit board 1 become difficult when the area of the partitioned portion is lesser than 200 mₘ₂.

The arrangement of the engagement section 21 a is the same as the engagement section 21 in the second embodiment.

Mode of the engagement sections 21 b is not specially limited as possible as fixing the printed circuit board 1 and the lens board 20. But, the engagement section 21 b is preferable to be a rivet shape which is formed by that the forming resin passes through the through holes 11 penetrating the printed circuit board 1 in the thickness direction so that the forming resin is filled in the rear face side of the printed circuit board, as is illustrated in the cross sectional view of Fig. 7.

In this case, a shape of the through hole 11 is possible to be a circle shape, a square shape and the like. But, the shape of the through hole 11 is not limited to these shapes.

Further, a size of the through hole 11 varies depending upon the size of the LED aggregate module. For example, the size of the through hole 11 is preferable to be about 1-30 mm² in an usual case, when the LED aggregate module has a shape of parallelogram of 60 mm X 60 mm. In this case, when the size of the through hole 11 is lesser than 1 mm², the printed circuit board 1 and the lens board 20 are not stably fixed to one another. While, when the size of the through hole 11 exceeds 30 mm², the force caused by resin shrinking is not dispersed so that warp is generated in the LED aggregate module M. Thereby, it is not preferable that the size of the through hole 11 is determined to be outside the range of 1-30 mm².

Further, it is preferable that each engagement sections 21 b is formed at a location apart by a distance of 0.5-10.mm, respectively, from two edges uniting the corner section which locates in diagonal direction from the corner section 22 of the lens board 20 which corner section 22 locates corresponding to each apex of the printed circuit board 1, because the lens board 20 is stably fixed to the printed circuit board 1.

A number and locations of the engagement sections 21 a and 21 b are not limited to the locations illustrated in Fig. 5. The number of the engagement sections 21 a and 21 b is sufficiently to be two points, and the locations of the engagement sections 21 a and 21 are sufficiently to have at least a distance to some degree therebetween.

As to the arrangement above-mentioned, though multiple number of lens board 20 are formed each having the small area for covering the printed circuit board on which the LED chips 2 are mounted, and the printed circuit board 1 on which the LED chips 2 are mounted is engaged and held by the engagement sections 21 a and 21b, the engagement section 21 a being formed in one body in each edge portion excluding the corner section 22 of the lens board 20 corresponding to the apex of the printed circuit board 1, and the engagement section 21 being formed in the corner section locating in diagonal direction with respect to the corner section 22, the resin shrinking of the lens board 20 partially occurs as that an internal stress is decreased. Though the internal stress is decreased, as is described in the foregoing, warp of the LED aggregate module is greatly suppressed.

As is described in detail in the foregoing, as to the LED aggregate module according to this embodiment, though the printed circuit board 1 on which the LED chips 2 are mounted is engaged by the engagement sections 21 a and 21 formed in one body in the lens board 20 when the lens board 20 is formed, adhesive agent which is required in the conventional LED aggregate module is not needed at all. Also, disadvantage in containing bubbles in the adhesive agent layer when the printed circuit board 1 and the lens board 20 are adhered to one another, and labor for assembling the printed circuit board 1 and the lens board 20 such as matching operation of optical axes of light emitting sections each section has the LED chip as a main portion and of the lens sections of the lens board 20 are eliminated.

Further, though the engagement section 21 a is formed in the edge portion excluding the corner sections of the lens board 20, shrinking forces in diagonal directions of the lens board 20 after formation of the lens board 20 are released. And though the lens board is divided into plural number of lens boards 20 each having a small area, and the lens boards 20 are formed on the printed circuit board 1, the resin shrinking of the lens board 20 is partially generated so that the internal stress decreases. As a result, warp of the LED aggregate module is suppressed.

Therefore, by employing this embodiment, the LED aggregate module is obtained which is easy in fixation of the printed circuit board 1 and the lens board 20, and has small warp of the printed circuit board 1 caused by the resin shrinking of the lens board 20, and has high reliability. Especially, fixing ability of the printed circuit board 1 and the lens board 20 is satisfactory when the LED aggregate module is large in size.

### Fourth Embodiment

Figures 8(A) to 8(C) are vertical cross sectional views of another embodiment of a method for manufacturing the LED aggregate module. As is illustrated in Fig. 8(A), LED chips 2 and electronic parts 3 such as resistor and the like mounted and fixed in one body by soldering and the like on a printed circuit board 1 on which printed circuit having a predetermined pattern is formed. The printed circuit board 1 is, for example, a printed circuit board performing high radiating performance which is obtained by forming an insulation layer on a surface of an alminium board and the like, then the prited circuit is formed on a surface of the insulation layer. In this case, mounting condition of the electronic parts 3 is determined so that central axis of the electronic parts 3 as many as possible is orthogonal to a flowing direction of translucent synthetic resin for forming a lens board 20 which is described later.

In this condition, a protection layer 3a is formed with a synthetic resin having a higher melting temperature than that of the translucent synthetic resin so as to cover edge portions of each electronic parts 3 in the flowing direction of the translucent synthetic resin, as is illustrated in Fig. 8(B). Thereafter, the lens board 20 is formed in one body with the printed circuit board 1 by insert molding the lens board 20, on which printed circuit board 1 the LED chips 2 and the electronic parts 3 are mounted, as is illustrated in Fig. 8(C).

Further in this case, the employed electronic parts 3 is preferable to be an electronic parts having a column-like outer shape, but elecrtonic parts having a rectangular cross sectional shape and electronic parts having an arbitrary shape may be employed.

Therefore, containing of bubbles is reduced to almost zero when the lens board 20 is formed in one body with the printed circuit board 1 in comparison to the case that adhesive agent is used to fix the lens board to the printed circuit board. Also, necessity is reduced to zero for special matching operation of the optical axes of light emitting sections each section has the LED chip as a main portion and of the lens sections of the lens board 20.

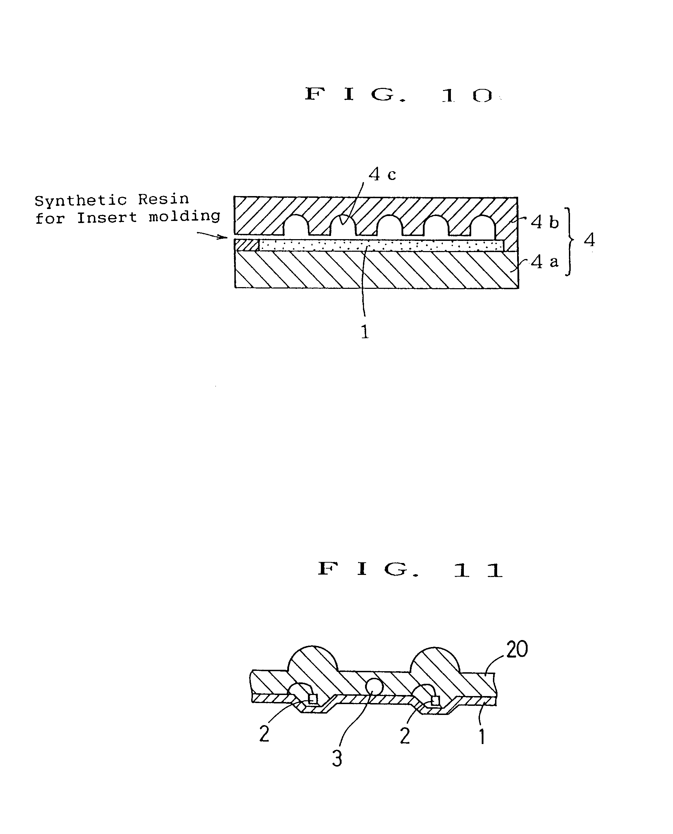

Further, the shape of the protection layer 3a is preferably determined to be a shape, as is illustrated in Fig. 9 for example, which shape has a smooth surface shape for acting resistance against the flow of the synthetic resin for inset molding (refer to an arrow in Fig. 9) as little as possible. The protection layer 3a may be formed so as to cover the whole extent of the electronic parts 3.

As to the method for manufacturing an LED aggregate module above-mentioned, when not only the LED chips 2 but also the electronic parts 3 are mounted on the printed circuit board 1, each of the protection layers 3a is formed on each electronic parts 3, and then the printed circuit board 1 is set in a molding die for insert molding the lens board 20, a cross sectional area for flowing the synthetic resin for insert molding is great thereby a pressure caused by the flowing of the synthetic resin does not increase so much, because the LED chips 2 are mounted at locations each of which is covered by each lens section of the lens board 20. Therefore, a disadvantage scarcely arise in that the LED chips 2 are breaked following the injection of the synthetic resin for insert molding. On the other hand, the electronic parts 3 are mounted on the printed circuit board 1 at locations not for influencing to the optical characteristics of the LED chips 2 and the lens sections, that is at locations each of which is not covered by each lens section, thereby a cross sectional area for flowing the synthetic resin for insert molding is extremely small. Therefore, a pressure caused by the flowing of the synthetic resin remarkably increases. But, a disadvantage is prevented from occurring that the pressure is concentrated a part of the electronic parts 3, because the protection layer 3a is formed at the edge portions of the electronic parts 3 in the flowing direction of the synthetic resin. Consequently, a disadvantage is prevented from occurring that the electronic parts 3 are breaked, in spite of the pressure being remarkably great caused by the flowing of the synthetic resin. Thereby, yield of the LED aggregate module is greatly improved.

### Specific Example

Resistors 3 as the electronic parts are previously soldered at four locations to the printed circuit board 1 having a rhomboid shape, and 6 X 6 number of LED chips 2 are previously mounted in matrix pattern on the printed circuit board 1. And, the printed circuit board 1 on which the LED chips 2 and the resistors 3 are mounted is inserted and positioned in a gap between an upper die 4b and a lower die 4a, as is illustrated in Fig. 10. The lower die 4a supports the printed circuit board 1, the upper die 4b has cavities 4c at locations each corresponding to each LED chip 2, the cavity 4c has a shape matching to the shape of lens section which is to be formed, and the lower die 4a and the upper die 4b are disposed in opposing condition. Then, polycarbonate is injected with a predetermined resin pressure and flowing velocity from a resin injection opening of an insert molding die 4 comprising the upper die 4b and the lower die 4a. Thereafter, an LED aggregate module is obtained by solidifies the polycarbonate.

In this case, column-shaped resistors are employed as the resistors 3, and percent defective is measured in a case that the protection layers 3a are formed, and in a case that no protection layers are formed. In the former case, percent breakage of the resistor 3 and of the soldered section are both 0%, while in the latter case, percent breakage of the resistor 3 and of the soldered section are 0% and 33%, respectively. When rectangular resistors are employed as the resistors 3, and percent defective is measured in a case that the protection layers 3a are formed, and in a case that no protection layers are formed. In the former case, percent breakage of the resistor 3 and of the soldered section are 16% and 0%, respectively, while in the latter case, percent breakage of the resistor 3 and of the soldered section are 33% and 25%, respectively. Further, the measurement of percent breakage is carried out by manufacturing 10 number of LED aggregate modules by the method for manufacturing above-mentioned, and by detecting breakage of the 10 number of LED aggregate modules.

### Fifth Embodiment

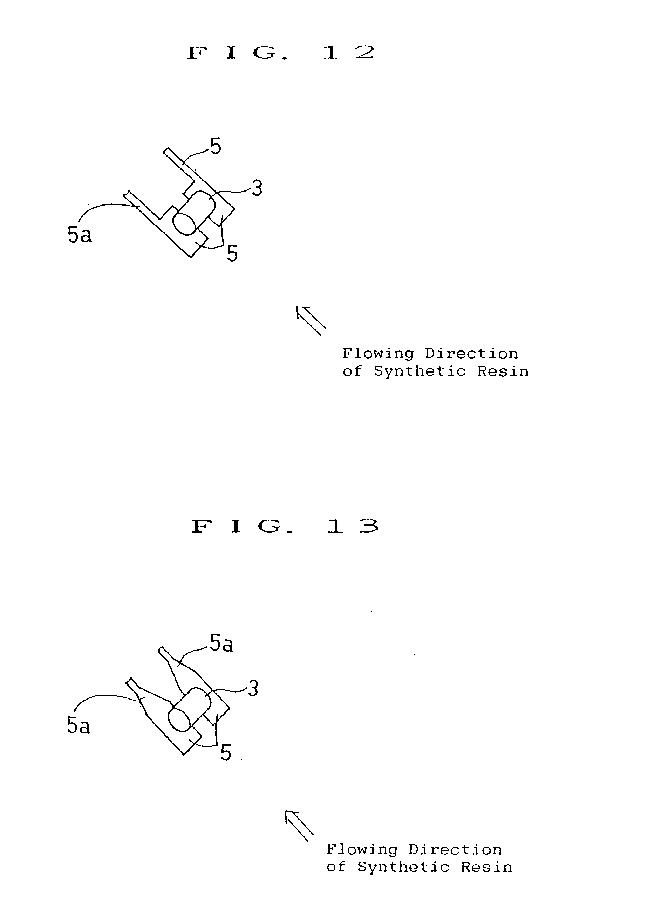

Figure 11 is a vertical cross sectional view illustrating a further embodiment of an LED aggregate module, while Figure 12 is a perspective view schematically illustrating mounted condition of an electronic parts.

LED chips 2 and electronic parts 3 such as resistor are mounted at predetermined locations on a printed circuit board 1 on which a predetermined printed pattern is formed, and are fixed in one body to the printed circuit board 1 by soldering them to land sections on the printed circuit board 1. And, a relative location of the printed circuit 5a with respect to the land section 5 is determined so that the printed circuit 5a extends from the land section 5 in a downstream side in a flowing direction of synthetic resin for a lens board 20.

In this condition, the lens board 20 is formed in one body to the printed circuit board 1 on which the LED chips 2 and the electronic parts 3 are mounted, by insert molding the lens board 20.

In this case, the electronic parts 3 is preferable to have a column-like outer shape, but the electronic parts 3 may have a rectangular cross sectional shape, or an arbitrary shape. Also, it is preferable that synthetic resin injection openings are formed at every predetermined distance corresponding to one edge of the printed circuit board 1 for the purpose of seizing the flowing direction of the synthetic resin, so that the flowing direction of the synthetic resin is almost constant to its entirety. It is possible that a number of synthetic resin injection openings is determined to be one, in this case, it is sufficient that the flowing direction of the synthetic resin with respect to each electronic parts is previously obtained by fluid analysis and the like, for example.

As to the LED aggregate module having the arrangement above-mentioned, a force caused by the flowing of the synthetic resin acts on the electronic parts 3 when the synthetic resin for insert molding is injected in a die, thereby there is possibility that the land sections 5 are peeled from the printed circuit board 1 to some degree. But, the peeling of the land sections 5 is scarcely occurred in connection to the printed circuit 5a, therefore cutting of the printed circuit 5a is securely prevented even when the peeling of the land sections 5 has occurred. Of course, though the lens board 20 finally covers the printed circuit board 1 in its entirety, small peeling of the land sections 5 never badly influence the characteristics of the LED aggregate module.

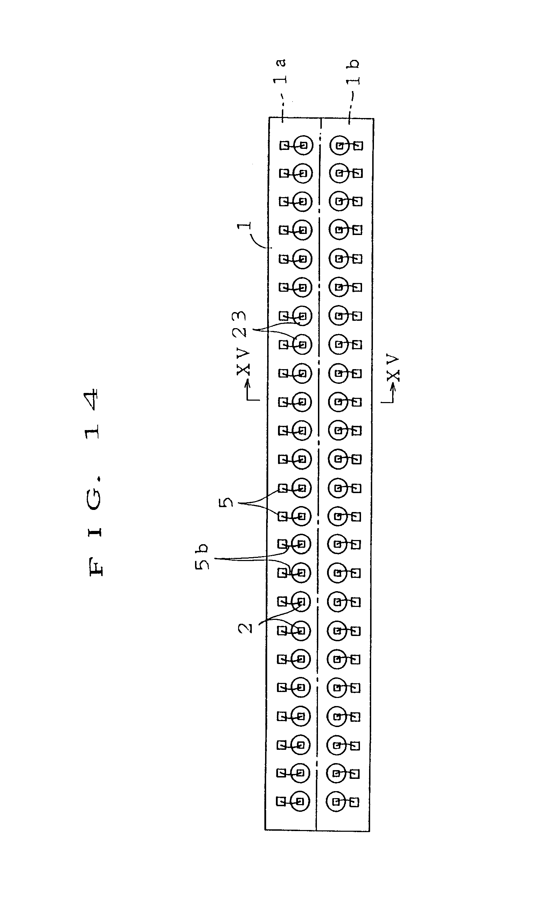

Further in this case, cutting of the printed circuit 5a is more securely prevented by determining a proportion of the width of the printed circuit 5a with respect to that of the land section 5 to gradually decrease following aparting from the land section 5, as is illustrated in Fig. 13.

Furthermore, the printed circuit 5a may be determined to extend in the upstream side in the flowing direction of the synthetic resin with respect to the land section 5, cutting of the printed circuit 5a is almost securely prevented.

### Specific Example

Resistors 3 as the electronic parts are previously soldered at four locations to the printed circuit board 1 having rhomboid shape, and 6 X 6 number of LED chips 2 are previously mounted in matrix pattern on the printed circuit board 1. And, the printed circuit board 1 on which the LED chips 2 and the resistors 3 are mounted is inserted and positioned in a gap between an upper die 4b and a lower die 4a, as is illustrated in Fig. 10. The lower die 4a supports the printed circuit board 1, the upper die 4b has cavities 4c at locations each corresponding to LED chip 2, the cavity 4c has a shape matching to the shape of lens section which is to be formed, and the lower die 4a and the upper die 4b are disposed in opposing condition. Then, polycarbonate is injected with a predetermined resin pressure and flowing velocity from a resin injection opening of an insert molding die 4 comprising the upper die 4b and the lower die 4a. Thereafter, an LED aggregate module is obtained by solidifies the polycarbonate.

In the LED aggregate module obtained by such manufacturing method, there are scarce cutting of the printed circuit.

### Sixth Embodiment

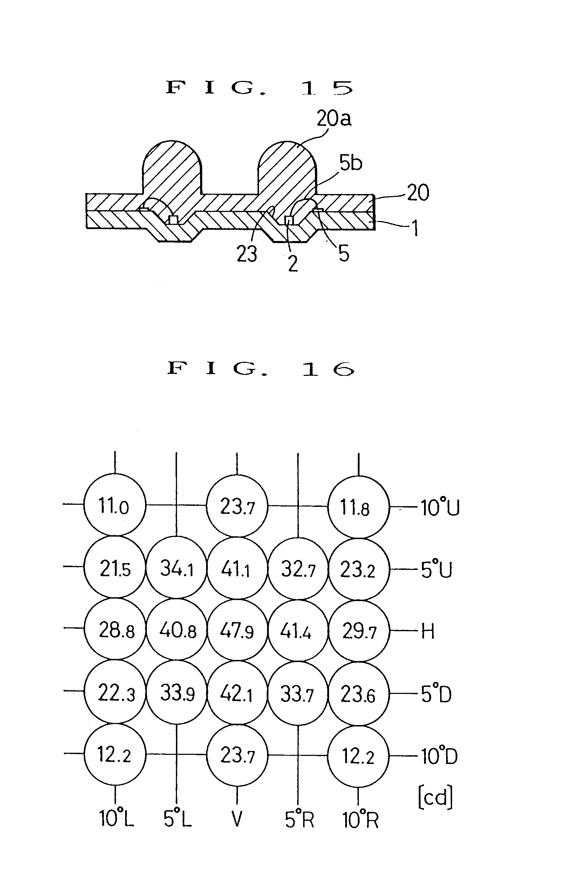

Figure 14 is a plan view illustrating a still further embodiment of an LED aggregate module, while Figure 15 is a cross sectional view taken along the XV-XV line in Fig. 14.

2 X 24 number of LED chips 2 are mounted in matrix pattern on a printed circuit board 1 having a rectangular shape and on which printed circuit is formed. And, the LED chips 2 are vertually partitioned in blocks of 1 X 24 number of LED chips 2 (refer to a dot-and-chain line in Fig. 14). With respect to the LED chips 2 belonging to one partition 3a (refer to upper half in Fig. 14), land sections 5 are disposed in the upper side in Fig. 14 each of which is connected to corresponding LED chip 2 with a bonding wire 5b. On the contrary, with respect to the LED chips 2 belonging to the other partition 3b (refer to lower half in Fig. 14), land sections 5 are disposed in the lower side in Fig. 14 each of which is connected to corresponding LED chip 2 with a bonding wire 5b. Further, each section indicated with a circle surrounding each LED chip 2 in Fig. 14 is a hollow section 23 for mounting the LED chip 2. The hollow section 23 is a hollow 23 having a reverse truncated cone shape. The hollow 23 enables the LED chip 2 being mounted not to project upward from a furface of non- hollow portion of the printed circuit board 1, and efficiently guide light outgone from the LED chip 2 to a lens section which is described later. Thereby, the inner entire face of the hollow section 23 is like a mirror.

Further, a lens board 20 is formed by insert molding so as to cover the upper face of the printed circuit board 1, and an optical axis of each of lens sections 20a of the lens board 20 is matched with an optical axis of corresponding LED chip 2 so that both optical axes are coincident to one another. Furthermore, synthetic resin for insert molding is exemplified with thermoplastic resin such as polycarbonate, polymethylmethacrylate (PMMA), polypropylene, 4-methylpentene-1 polymer and the like.

As to the LED aggregate module having the arrangement above-mentioned, light outgone from the LED chips 2 belonging to the one partition 3a is screened by bonding wires 5b in the upper side in Fig. 14, so that quantity of outgone light in this portion becomes smaller than that of the other portion. On the contrary, light outgone from the LED chips 2 belonging to the other partition 3b is screened by bonding wires 5b in the lower side in Fig. 14, so that quantity of outgone light in this portion becomes smaller than that of the other portion. That is, in each partition, when it is observed partially, the light outgone from the LED chip 2 is partially screened by the bonding wire 5b, so that dispersion is occurred to some degree in light distribution characteristics. But, the LED aggregate module functions in its entirety as a plane illuminant. On an illuminated face which receives influence of the both partitions nearly uniformly, the light distribution characteristics different from one another are overlapped to one another, so that dispersion in light distribution characteristics is greatly decreased.

Specifically, when the light distribution characteristics are measured using the LED aggregate modules having the arrangement illustrated in Fig. 14 and Fig. 15, measurement result illustrated in Fig. 16 is obtained. In this measurement, an LED chip made of GaAIAs, having a length, width and height of 300 µm, 300 µm and 180 µm, respectively, and having output of 30 milli-candela (mcd) is employed as the LED chip 2, a bonding wire having a diameter of 30 µm is employed as the bonding wire 5b. Also, a diameter of an opening section of the hollow section 23 is determined to be 1.4 mm, a diameter of a botton section of the hollow section 23 is determined to be 0.6 mm, a depth of the hollow section 23 is determined to be 0.4 mm, and an inclination angle of a side face of the hollow section 23 is determined to be 45°. Further, a lens board made of polycarbonate and has aspherical lenses of 06mm is employed as the lens board 7. And, luminosity at plural points on a measurement plane is measured in a condition that a center of the LED aggregate module having the arrangement illustrated in Figs. 14 and 15 is coincident to a location which is apart from a cross point of a horizontal axis H and a vertical axis V of the measurement plane by 3 m in a direction vertical to the measurement plane, and that the LED aggregate module is kept vertically. Further, in Fig. 16, 100 U indicates a location on the measurement plane which is upward by 10 from the center of the LED aggregate module with respect to the horizontal direction. 5 _{°} U indicates a location on the measurement plane which is upward by 5 °, similarly. Further, characters "D", "R", and "L" added after a value indicating an angle indicate downward, rightward, and leftward, respectively.

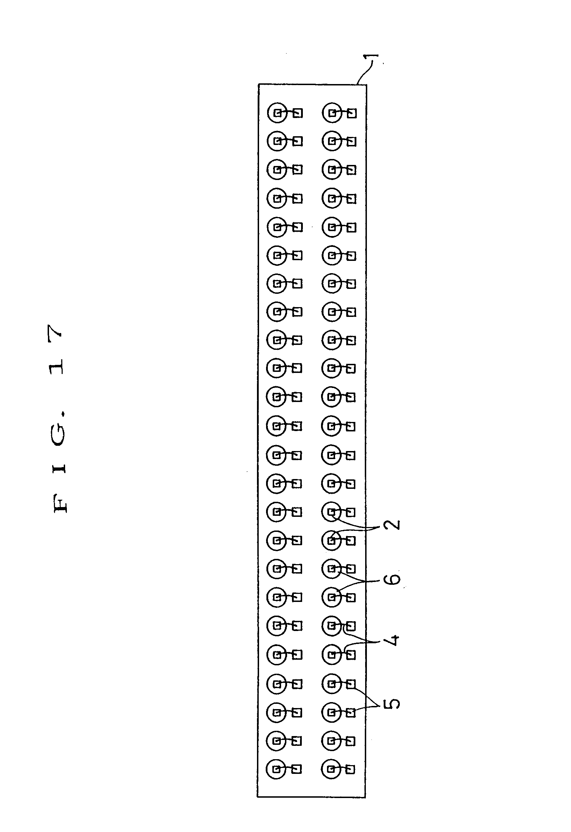

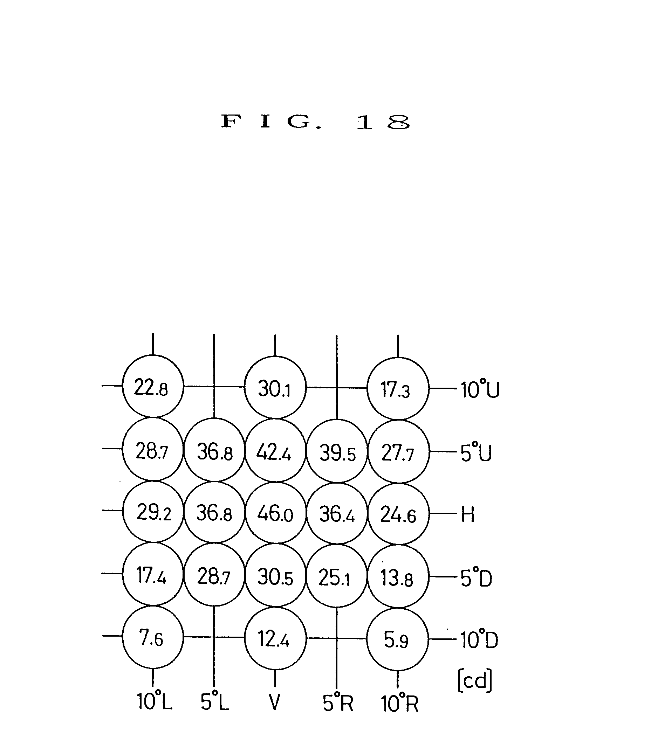

As a comparison example, as is illustrated in Fig. 17, an LED aggregate module is used for light distribution chatacteristics measurement in which land sections are formed in a lower side in Fig. 17 with respect to all 2 X 24 number of LED chips in matrix pattern disposition, and all bonding wires extend to downward in Fig. 17. Then, measurement result illustrated in Fig. 18 is obtained.

When the both light distribution characteristics measurement results are compared to one another, in the light distribution chracteristics in Fig. 18, the quantity of light in a region of 5 _{°} D is lower to some degree in comparison with the quantity of light in a region of 5°U, and the quantity of light in a region of 10°D is remarkably lower in comparison with the quantity of light in a region of 10°U. Over against this, in the light distribution chracteristics in Fig. 16, the quantity of light in a region of 5 _{°} D is nearly equal to the quantity of light in a region of 5°U, and the quantity of light in a region of 100 D is nearly equal to the quantity of light in a region of 100 U.

Therefore, by partitioning the LED chips into two partitions, and by determining the relative positioning of the land sections with respect to corresponding LED chip in each partition in reverse positioning to one another, dispersion in light distribution characteristics is greatly decreased so that the LED aggregate module functions as sufficiently homogenious plane illuminant.

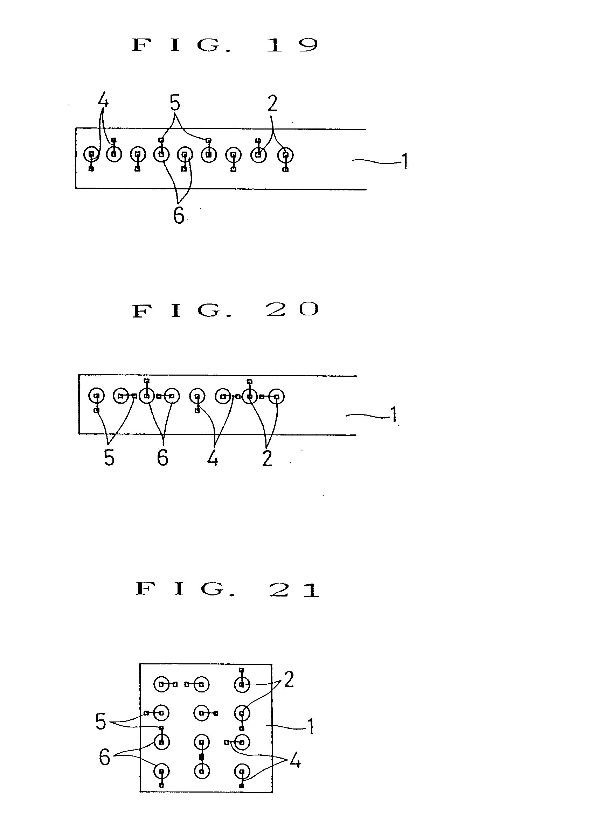

Further, this invention is not limited to the above-mentioned embodiment. For example, as is illustrated in Fig. 19, it is possible that a partitioning unit of a line type LED aggregate module is determined to be one LED chip, and that the land sections 5 are alternately provided in upper side and lower side with respect to corresponding LED chips 2. As is illustrated in Fig. 20, it is possible that the land sections 5 are sequentially provided in lower side, right side, upper side, and left side. Further as is illustrated in Fig. 21, it is possible that a partitioning unit of a matrix type LED aggregate module is determined to be one LED chip, and that the land sections 5 are suitably provided in different direction with respect to corresponding LED chip 2. It is possible that a non-metallic printed circuit board is employed, and that a printed circuit board having no hollow sections is employed. Various modifications are applicable within an extent not varying the scope of this invention.

### Seventh Embodiment

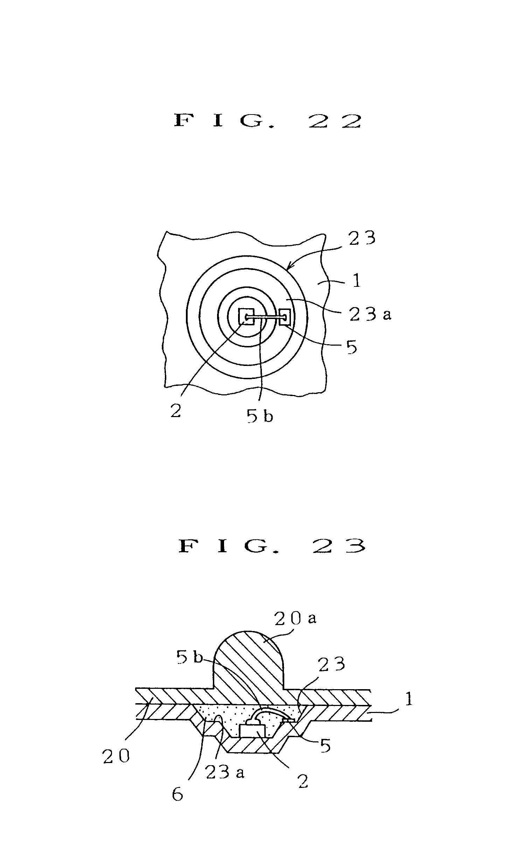

Figure 22 is a plan view illustrating a main portion of yet another embodiment of an LED aggregate module, while Figure 23 is a vertical sectional view of the LED aggregate module in Fig. 22.

In an LED aggregate module illustrated in Fig. 22, hollow sections 23 are formed at every predetermined distance on a surface of a printed circuit board 1 on which a printed circuit if formed, and an LED chip 2 is mounted on a bottom face of each hollow section 23 interposing a land section which is not illustrated. And, the hollow section 23 is formed to be a shape of reverse truncated cone having a step section. The step section 23a is determined to be a plane in parallel to a printed circuit formed face of the printed circuit board 1. A land section 5 connected to the LED chip 2 with a bonding wire 5b is formed on a predetermined location of the step section 23a. And, the bonding wire 5b bonded to the LED chip 2 and the land section 5 in a condition that the bonding wire 5b to its entirety is positioned lower than the printed circuit formed face of the printed circuit board 1. Bonding the bonding wire 5b in such manner is performed easily by taking a condition into consideration that the upper face of the LED chip 2 and the land section 5 both are positioned lower than the printed circuit formed face of the printed circuit board 1. Further, silicon resin 6 for protecting the bonding wire 5b is housed in the hollow section 23 so as to make the upper face of the silicon resin flat and coincident with the prited circuit formed face of the printed circuit board 1. Furthermore, a lens board 20 if formed in one body by insert molding on the printed circuit board 1.

As to the LED aggregate module having the arrangement above-mentioned, though the upper face of the silicon resin 6 is flat and coincident with the printed circuit formed face of the printed circuit board 1, the silicon resin 6 has no lens characteristics. Thereby, only lens sections 20a of the lens board 20 have the lens characteristics. Though the lens chatacteristics of the lens section 20a is determined based upon the species of synthetic resin for insert molding, and a shape of the lens section 20a, an LED aggregate module having the optical characteristics according to a design is easily obtained. Further, influence of depression of the synthetic resin for insert molding never concentrate locally, therefore influence of inner reflection of outgone light from the LED chip caused by the depression is greatly decreased so that lowering of outgone light intensity is greatly suppressed. Of course, interconnection of the LED chip 2 and the land section 5 with the bonding wire 5b is not damaged at all.

### Eighth Embodiment

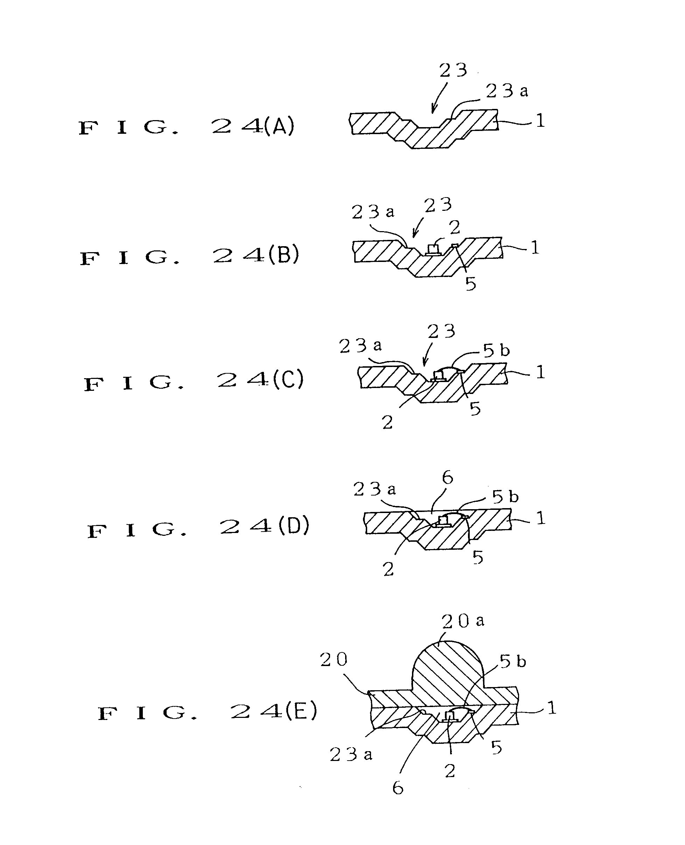

Figures 24(A)-(E) are vertical sectional views explaining a further embodiment of a method for manufacturing an LED aggregate module.

Hollow sections 23 having a shape of a reverse truncated cone having a step section are formed in predetermined locations of a printed circuit board 1 by applying drawing and the like to the printed circuit board 1 {refer to Fig. 24(A)}.

Then, a printed circuit which is not illustrated is formed on a surface of the printed circuit board 1, and simultaneously, land sections 5 are formed on a bottom face and the step section 23a of each hollow section 23, then an LED chip 2 is mounted on the land section formed on the bottom face of each hollow section 23 {refer to Fig. 24(B)}.

Thereafter, the LED chip 2 and the land section 5 formed on the step section 23a are interconnected with a bonding wire 5b {refer to Fig. 24(C)}. In this condition, length and degree of curvature of the bonding wire 5b is determined so that the uppermost portion of the bonding wire 5b is positioned lower than the printed circuit formed face of the printed circuit board 1. Though, the step section 23a has a face which is parallel to the surface (printed circuit formed face) of the printed circuit board 1 and the land section 5 is formed on the face, bonding of the bonding wire 5b to the land section 5 is easily and securely performed.

After the interconnection with the bonding wire 5b is performed, a silicon resin 6 for protecting the bonding wire is housed in the hollow section 23 so that the upper face of the silicon resin is made flat and coincident with the printed circuit formed face of the printed circuit board 1 {refer to Fig. 24(D)}.

Finally, a lens board 20 is formed in one body on the printed circuit board 1 by insert molding so that an LED aggregate module is obtained {refer to Fi g . 24(E)} .

Therefore, by executing the method for manufacturing an LED aggregate module, an LED aggregate module is easily obtained which has the optical characteristics according to a design and greatly suppresses lowering of outgone light intensity.

Further, this invention is not limited to the above-mentioned embodiment. It is possible that a reverse truncated elliptical cone shape and the like is employed as a shape of the hollow section 23 instead of the reverse truncated cone shape. It is possible that the step section 23a is formed in only a local portion. Various modifications are applicable within the extent without varying the scope of this invention.

## Claims

1. A light emitting diode aggregate module in which lenses (20a) formed with translucent resin are disposed on a surface of a printed circuit board (1) on which plural light emitting diode chips (2) are mounted, each of the lenses (20a) corresponding to each light emitting diode chip (2), the light emitting diode aggregate module being characterized in comprising;
a metallic base printed circuit board (1) having plural hollows (23) thereon, a predetermined printed pattern, light emitting diode chips (2) each mounted in a bottom portion of each hollow (23), and electronic parts (3) each mounted at a location which is different from a mounted location of the light emitting diode chip (2),
a soft resin layer (6) for surrounding peripheral portion of the light emitting diode chip (2),
a protection layer (3a) made of resin for covering a part or entirety of the electronic parts (3), and
a lens board (20) which is formed by injection of translucent resin into a die and is disposed in contact on a surface of the printed circuit board (1), the lens board (20) covering the plural light emitting diode chips (2) and the electronic parts (3), and having lens sections (20a) projecting forward at a location corresponding to each light emitting diode chip (2).

2. A light emitting diode aggregate module as set forth in claim 1, wherein the printed circuit board (1) has a rectangular shape, and further comprises claw sections (21)(21a) which are formed in one body at edge sections excluding corner sections (22) of the lens board (20) so that fixation of the printed circuit board (1) and the lens board (20) is performed by the claw sections (21 )(21 a).

3. A light emitting diode aggregate module as set forth in claim 1 or 2, further comprising through holes (11) in the printed circuit board (1) so that fixation of the printed circuit board (1) and the lens board (20) is performed by going round the resin for lens board to an opposite face side of the printed circuit board (1) through the through holes (11).

4. A light emitting diode aggregate module as set forth in claim 3, wherein the through holes (11) are provided in vicinity of the light emitting diode mounting portion, and the light emitting diode (2) is substantially surrounded with the resin for the lens board (20).

5. A light emitting diode aggregate module as set forth in one of claims 1 to 4, wherein the protection layer (3a) for the electronic parts (3) is formed in a shape which reduces resistance against the flowing of the translucent resin for lens board (20) when the translucent resin is injected in a molding die (4).

6. A light emitting diode aggregate module as set forth in one of claims 1 to 5, further comprising a printed circuit (5a) and land sections (5) formed on the printed circuit board (1), and wherein the printed circuit (5a) extending from the land section (5) among the printed circuit on the printed circuit board (1), is provided in a direction of flowing of the translucent resin when the translucent resin is injected in a molding die (4), the land section (5) being electrically connected the electronic parts (3) at least.

7. A light emitting diode aggregate module as set forth in one of claims 1 to 6, further comprising a soft resin layer (6) for covering peripheral portion of the light emitting diode chip (2), the soft resin layer (6) being housed in the hollow (23) so as to make a surface of the soft resin layer (6) flat and coincident with the surface of the printed circuit board (1).

8. A light emitting diode aggregate module as set forth in one of claims 1 to 7, further comprising a step section (23a) which is provided in a predetermined location of each hollow (23).

9. A light emitting diode aggregate module as set forth in one of claims 1 to 8, wherein the land section (5) on the printed circuit board (1) is connected to an upper electrode of the light emitting diode chip (2) by a bonding wire (5b), extending directions of the bonding wire (5b) with respect to the light emitting diode chip (2) are determined at least two directions, a number of the bonding wires (5b) extending in each direction is determined nearly equal to one another, for preventing the light emitting diode aggregate module from not obtaining sufficient plane luminance characteristics caused by screening of light radiated from the light emitting diode chips (2) by the bonding wires (5b).

10. A method for manufacturing a light emitting diode aggregate module in which lenses (20a) formed with translucent resin are disposed on a surface of a printed circuit board (1) on which plural light emitting diode chips (2) are mounted, each of the lenses (20a) corresponding to each light emitting diode chip (2), the method being characterized in comprising the steps of;
a step for housing a printed circuit board (1) on which light emitting diode chips (2) are mounted in a molding die (4) which has plural cavities (4c) for lens corresponding to a front face side of the printed circuit board (1), and
a step for injecting translucent resin for lens board in the molding die (4) through one or more injection gates (17) and runners (17b) which are provided in the molding die (4) so that the translucent resin once collides against the front face of the printed circuit board (1), then the translucent resin flows into the cavities (4c) along the front face of the printed circuit board (1).

11. A method as set forth in claim 10, further comprising a step for forming through holes (11) in the printed circuit board (1) at locations each of which is near the mounted section of each light emitting diode chip (2), and is opposite to each cavity (4c) for lens, and
wherein the step for housing the printed circuit board (1) in the molding die (4) is a step for housing the printed circuit board (1) on which the light emitting diode chips (2) are mounted in the molding die (4) which has the plural cavities (4c) for lens corresponding to the front face side of the printed circuit board (1) and plural cavities (4d) for fixing lens corresponding to rear face side of the printed circuit board (1), each of the cavities (4d) facing to corresponding cavity (4c) for lens, and
the step for injecting the translucent resin for lens board is a step for injecting the translucent resin for lens board to flow into the cavities (4c) for lens and for injecting the translucent resin for lens board to flow into the cavities (4d) for fixing lens through the cavities (4c) for lens and the through holes(11).

12. A method as set forth in claim 10 or 11, further comprising a step for forming protection layers (6) made of soft resin on the surface of light emitting diode chips (2) mounted on the printed circuit board (1) prior to housing the printed circuit board (1) in the molding die (4).

13. A method as set forth in one of claims 10 to 12, further comprising a step for forming plural hollow sections (23) on the printed circuit board (1), and a step for mounting each of the light emitting diode chips (2) on a bottom portion of each hollow section (23).

14. A method as set forth in one of claims 10 to 13, further comprising a step for forming step sections (23a), each of which being in a predetermined location of each hollow section (23).

15. A method as set forth in one of claims 10 to 14, further comprising a step for mounting electronic parts (3) on the printed circuit board (1), and
a step for covering a part or entirety of each mounted electronic parts (3) with a protection layer

16. A method as set forth in one of claims 10 to 15, further comprising a step for mounting light emitting diode chips (2) on the printed circuit board (1) in an arranged in matrix pattern condition, and
wherein plural injection gates (17) are formed in the molding die (4), a number of injection gates (17) corresponding to a mounted number of the light emitting diode chips (2) and each injection gate (17) being located at nearly central position of more than two mounted light emitting diode chips (2) on the front face of the printed circuit board (1), and the translucent resin for lens is injected from each injection gate (17), respectively.

17. A method as set forth in one of claims 10 to 16, further comprising a step for forming a soft resin layer (6) which covers all surface of each light emitting diode chip (2), and surface of which is determined to be flat and coincident with the surface of the printed circuit board (1).
